# EUROPEAN PATENT SPECIFICATION

(11) **EP 3 745 595 B1**
(45) Date of publication and mention of the grant of the patent: **19.10.2022**
(21) Application number: 20187311.4
(22) Date of filing: 25.06.2018
(51) Int. Cl.: H03K 17/96

(54) **TOUCH SENSOR ASSEMBLY**
BERÜHRUNGSSENSORANORDNUNG
ENSEMBLE DE CAPTEUR TACTILE

(30) Priority: 23.06.2017 KR 20170079559; 26.06.2017 KR 20170080356
(43) Date of publication of application: 02.12.2020
(62) Divisional of application: 18179466.0
(73) Proprietor: LG Electronics Inc., Seoul 07336 (KR)
(72) Inventor: YANG, Jaesung, Seoul 08592 (KR); KIM, Hyunki, Seoul 08592 (KR); PARK, Seungje, Seoul 08592 (KR)
(74) Representative: Ter Meer Steinmeister & Partner

(56) References cited:
- EP-A1- 0 525 374
- US-A1- 2016 105 985

## Description

### BACKGROUND

The present specification relates to a touch sensor assembly.

Refrigerators may be classified into a top mount type refrigerator in which a freezing compartment is located above a refrigerating compartment, a bottom freezer type refrigerator in which a refrigerating compartment is located above a freezing compartment, and a side-by-side type refrigerator in which a refrigerating compartment and a freezing compartment are respectively located at left and right sides, according to the configurations of the refrigerating compartment and the freezing compartment.

The side-by-side type refrigerator is mainly released as a refrigerator having a relatively large capacity and various functions, and includes a freezing compartment and a refrigerating compartment which are vertically installed at the left and right sides of the refrigerator. An evaporator is provided on the rear surface of the freezing compartment to suck air from the lower portions of the freezing compartment and the refrigerating compartment and to discharge air upward, thereby circulating cool air in the compartments to perform the refrigerating function and the freezing function.

In general, refrigerator doors are rotatably installed on a front surface of a refrigerator and are exposed to a user in a state in which storage compartments are closed. In consideration of the usage of the refrigerator, in which a time to keep the refrigerator door open is small during a day, the front surface of the door of the refrigerator is decorated with a panel having various patterns or a front panel of the door is made of a luxurious exterior material, in order to provide an aesthetically pleasing appearance.

Recently, users have a high preference for a material of home appliances made of metal. When a display for confirming operation information of a refrigerator and buttons for operating the refrigerator are installed on a front surface of a door of the refrigerator, the appearance of the refrigerator may be deteriorated.

In consideration of this, recently, research into a door structure in which display information and buttons are not usually displayed and are displayed only when a user desires to view the display information and the buttons is actively being conducted.

It is difficult to apply an electrostatic touch method to a door having a front panel made of a metal material. In addition, since the metal material itself has certain rigidity, it is not easy to implement a static-pressure type touch method. In particular, it is difficult to implement a hidden button on a panel made of a metal material using a conventional touch sensing method.

Accordingly, there is a need for development of a sensor capable of reliably recognizing a touch operation even in a panel made of a metal material. Such a sensor is applicable not only to a front panel of a refrigerator door but also to various home appliances having a metal panel and capable of applying a hidden button for performing a touch operation to the metal panel and thus is widely used in various fields.

In the above-described metal touch sensor, when force applied upon touch is large or the number of times of pressing a button is increased, a pressing portion and the periphery thereof may be damaged with time.

However, in the related art, there is no countermeasure against such damage and thus a pattern connecting an electric signal cannot be prevented from being disconnected. EP 0 525 374 A1 discloses a piezoelectric key switch. The piezoelectric key switch includes a housing which contains a recess, which starts from its front. In the recess, a disc-shaped compensating element of rubber, a disc-shaped piezoceramic element mounted thereon, an annular spacer and an operating plate are located stacked on top of one another. All these elements are bonded to one another with their flat areas. The opening of the recess has an outside contour corresponding to the outside contour of the operating plate which is flush with the area of the front of the housing in the non-operated state. On the rear of the operating plate, protrusions protrude into the recess which limit the stroke of the operating plate.

### SUMMARY

An object of the present invention is to provide a touch sensor assembly having a small number of parts, a simple manufacturing method and high touch operation sensing reliability.

Another object of the present invention is to provide a touch sensor assembly capable of preventing a pattern connecting an electrical signal from being disconnected due to repeated use and fatigue accumulation.

Another object of the present invention is to provide a touch sensor assembly capable of operating even when any one pattern is disconnected.

Another object of the present invention is to provide a touch sensor assembly capable of preventing failure which occurs when a pattern connecting an electrical signal is disconnected and increasing the lifespan of a product.

Another object of the present invention is to provide a touch sensor assembly capable of reducing possibility of damage by forming a line, through which a pattern connecting an electrical signal passes, in the form of a curved line to increase a withstanding load as compared to a straight line.

Another object of the present invention is to provide a touch sensor assembly having high touch operation sensitivity.

Another object of the present invention is to provide a touch sensor assembly having robustness and high durability.

Another object of the present invention is to provide a touch sensor assembly having a high degree of freedom in design.

Another object of the present invention is to provide a touch sensor assembly which can be easily and manually manufactured and can be automated.

Another object of the present invention is to provide a touch sensor assembly which can be robustly assembled and can increase touch operation sensing reliability.

According to an aspect, a touch sensor assembly includes a touch substrate attached to a rear surface of a panel having a touch point, a piezo disk having first and second poles stacked thereon, wherein the first pole is disposed on at least a central portion of a front surface thereof and aligned in a direction facing the touch substrate to be fixed to a rear surface of the touch substrate, a pressing part flexibly provided on the touch substrate, electrically connected to the first pole upon being in contact with the first pole, and electrically connected to a plurality of wirings provided on the touch substrate at a plurality of points, and a fixing surface electrically connected to the second pole while supporting the second pole such that the piezo disk is fixed to the rear surface of the touch substrate and electrically connected to second wirings provided on the touch substrate. Accordingly, it is possible to prevent a pattern connecting an electrical signal from being broken by repeated use and fatigue accumulation and to perform operation even when any one pattern is broken.

In addition, a hole may be provided at a position of the touch substrate corresponding to the touch point, and the pressing part may be connected to the ends of a plurality of leg parts extending from inner circumferential surface of the hole to a central portion of the hole.

In addition, the plurality of first wirings may be electrically connected to the pressing part through the leg parts.

In addition, the leg parts may be radially provided around the pressing part. In addition, the leg parts may have an asymmetric structure with respect to the pressing part.

In addition, the leg parts and the first wirings passing through the leg parts may be formed in a curved shape.

In addition, a holder for providing fixing force for fixing the piezo disk to the rear surface of the touch substrate by supporting a side surface and a rear surface of the piezo disk may be fixed to the fixing surface.

In addition, the holder may be made of a conductive material, and the second pole of the piezo disk may be electrically connected to the fixing surface.

In addition, the holder may include a rear support part supporting a rear surface of the piezo disk. The holder may include a side support part extending from an edge of the rear support part toward the touch substrate to support the side surface of the piezo disk. The holder may include a fixing leg part extending from the side support part outwardly in a direction parallel to a plane including the touch substrate to be fixed to the fixing surface of the touch substrate.

In addition, an insertion hole opened to insert the piezo disk may be formed in one side of the rear support part. In addition, the insertion hole may be formed toward the outside of the touch substrate.

In addition, a guide groove recessed inward may be provided in an edge of the rear support part including the insertion hole in order to guide insertion of the piezo disk.

In addition, pressing projections protruding forwardly to press the rear surface of the piezo disk forwardly may be provided on the rear support part, and the pressing projections may press edges of the rear surface of the piezo disk.

In addition, a first adhesive member for providing adhesive strength to adhere the touch substrate to the rear surface of the panel may be stacked on a front surface of the touch substrate.

In addition, the touch sensor assembly may comprise an oxidation prevention film coated on at least one of the first pole or the second pole of the piezo disk and the pressing part or the fixing surface of the touch substrate and made of a conductive material. Accordingly, it is possible to prevent oxidation of the piezo disk and the touch substrate without a complicated sealing structure and to prevent electrical contact failure due to oxidation of the piezo disk and the touch substrate.

In addition, the oxidation prevention film may be made of carbon or gold (Au).

In addition, the oxidation prevention film may be coated using a silk screen method.

### BRIEF DESCRIPTION OF THE DRAWINGS

FIG. 1 is a view showing a front surface of a refrigerator, to which a touch sensor assembly according to the present invention is applied.
FIG. 2 is a perspective view showing a door portion of the refrigerator of FIG. 1.
FIG. 3 is a partial exploded perspective view of the refrigerator of FIG. 2.
FIG. 4 is an exploded perspective view of the touch sensor assembly shown in FIG. 3.
FIG. 5 is an enlarged view of a portion A of the touch substrate shown in FIG. 4.
FIG. 6 is a front view and a rear view showing the other embodiments of the portion of the touch substrate shown in FIG. 5.
FIG. 7 is an enlarged view and a side view of a portion B which is one of the piezo disks shown in FIG. 4.
FIG. 8 is an enlarged view of a portion C which is one of holders shown in FIG. 4.
FIG. 9 is a cross-sectional view of a piezo disk installation portion of the touch sensor assembly when viewed in an X-X direction of FIG. 2 in a state of assembling the touch sensor assembly of FIG. 4.
FIG. 10 is a front view showing a state in which the touch substrate, the holder and the piezo disk of the touch sensor assembly of FIG. 4 are assembled.
FIG. 11 is a rear view of FIG. 10.

### DETAILED DESCRIPTION OF THE EMBODIMENTS

Hereinafter, some embodiments of the present invention will be described in detail with reference to exemplary drawings. The present invention is not limited to the disclosed embodiments, but may be embodied in many different forms. The present embodiments are provided so that the disclosure of the present invention is complete and that those skilled in the art will fully understand the scope of the invention.

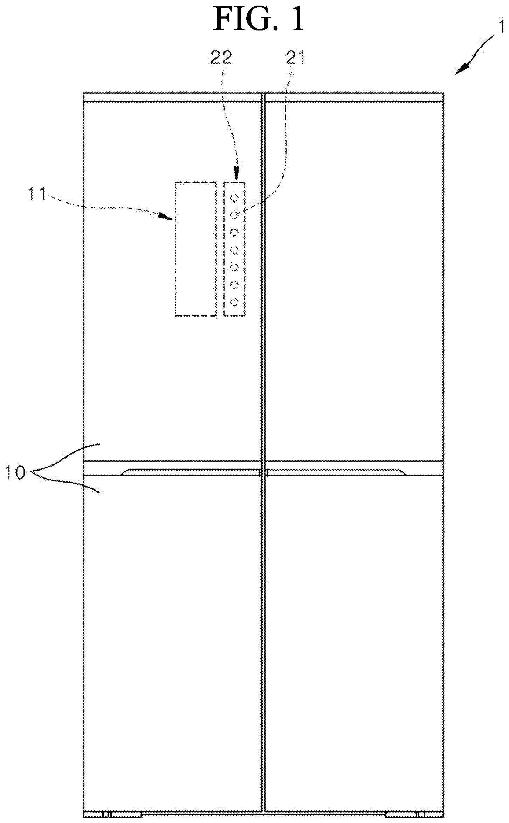

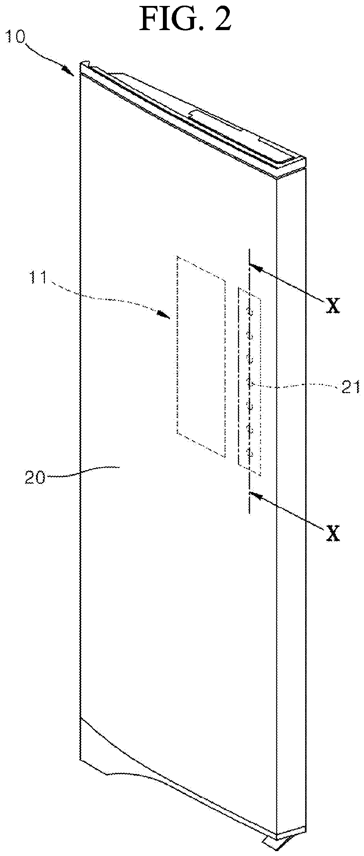

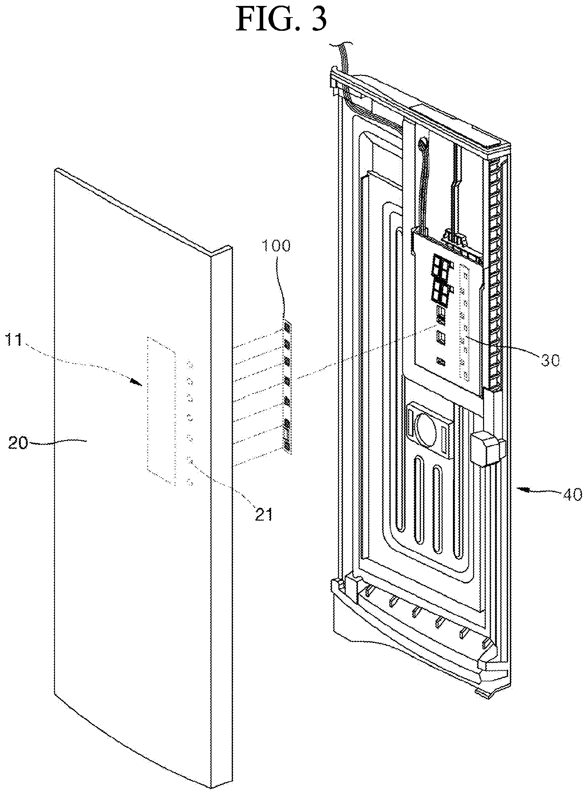

FIG. 1 is a view showing a front surface of a refrigerator, to which a touch sensor assembly according to the present invention is applied, FIG. 2 is a perspective view showing a door portion of the refrigerator of FIG. 1, and FIG. 3 is a partial exploded perspective view of the refrigerator of FIG. 2.

As shown in FIG. 1, the appearance of the refrigerator 1 according to the embodiment of the present invention is defined by a cabinet for providing a storage space and refrigerator doors 10 installed on the cabinet to open and close the storage space.

The storage space provided by the cabinet may be partitioned into left and right sides and/or upper and lower sides, and a plurality of refrigerator doors 10 for opening and closing the storage space is provided on a front surface of the partitioned storage space. The doors 10 are configured to open and close the storage space in a sliding or rotation manner and the doors configures the front appearance of the refrigerator in a state of closing the doors.

On a door 10, which corresponds to an eye level of a user having an average height, of the plurality of refrigerator doors 10, a display region 11 and a touch region 22 is provided at a height where a user can easily identify or operate the regions.

The display region 11 displays the operation state of the refrigerator 1 to the outside and is configured to display symbols or numerals as light irradiated from an internal space of the door 10 is transmitted (see FIG. 2), such that the user can check the operation information of the refrigerator.

When light is not irradiated from the internal space of the door, the display region 11 is not displayed (see FIG. 1). In this state, the display region 11 seems to be not present in the door 10, thereby implementing a clear appearance.

The touch region 22 is used for a user to perform a touch operation for operating the refrigerator 1 and is provided near the display region 11. A plurality of touch points 21 is provided in the touch region 22. When the user presses a touch point 21, an operation corresponding thereto is performed. The touch points 21 may be displayed to be recognized by the user by a printing process or a surface processing method such as etching.

Of course, the touch region 22 may not be installed on the same door 10 as the display region 11 and may be installed on another door 10 or on one side of a cabinet.

In addition, the touch points 21 may not be displayed so as to be always identified and the positions thereof may or may not be recognized depending on whether light is irradiated from the inside of the door or not, as in the display region 11.

A front panel 20 may be made of a metal plate such as a steel or stainless steel plate. A touch sensor assembly 100 is fixed to a rear surface of a portion corresponding to the touch region 22 of the front panel 20. A support structure 30 may be installed inside a door liner 40 fastened to the rear side of the front panel 20, in order to increase adhesive strength between the touch sensor assembly 100 and the front panel 20. When the front panel 20 and the door liner 40 are fastened in a state of fixing the touch sensor assembly 100 to the rear surface of the front panel 20, the support structure 30 installed on the door liner 40 presses the rear surface of the touch sensor assembly 100 to support the touch sensor assembly 100 forward.

In addition, by fastening the front panel 20 and the door liner 40 in a state of fixing the touch sensor assembly 100 to the front surface of the support structure 30, the front surface of the touch sensor assembly 100 may be adhered to the rear surface of the front panel 20. In addition, it should be understood that various supporting methods including a method of assembling the front panel 20 and the door liner 40 to support the touch sensor assembly 100 toward the front panel 20 are possible.

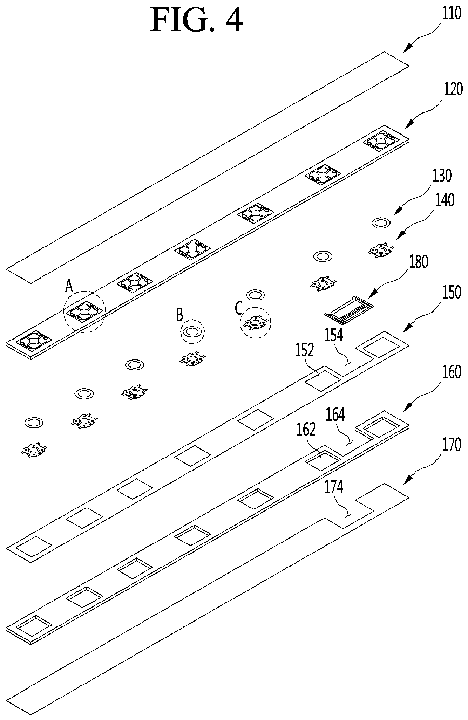

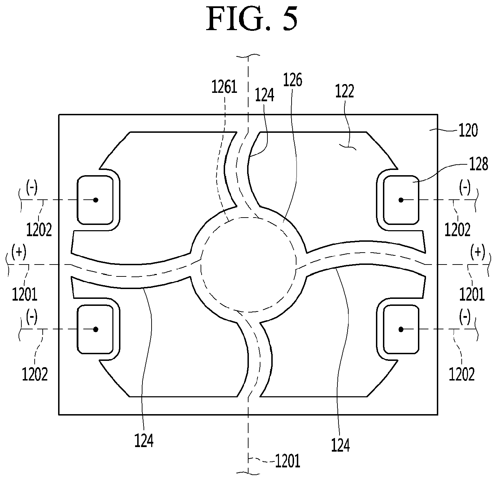

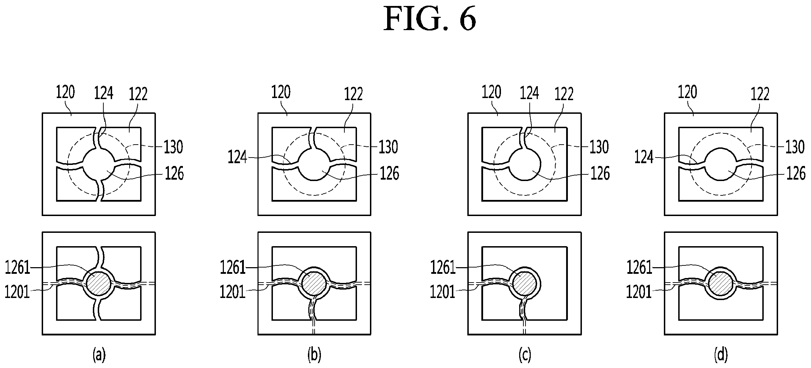

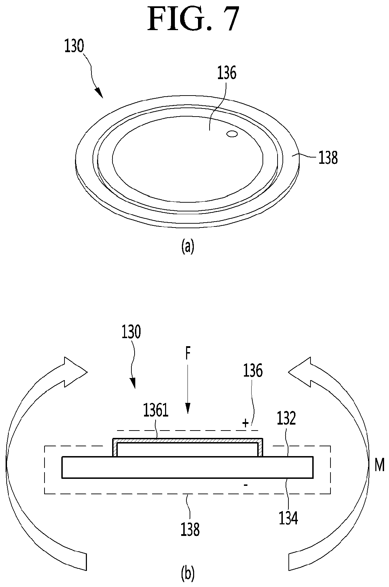

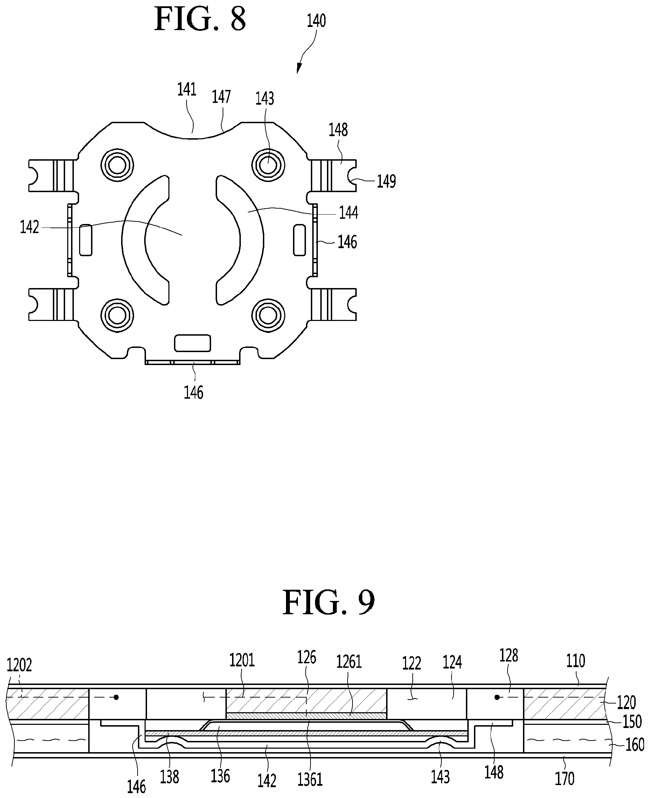

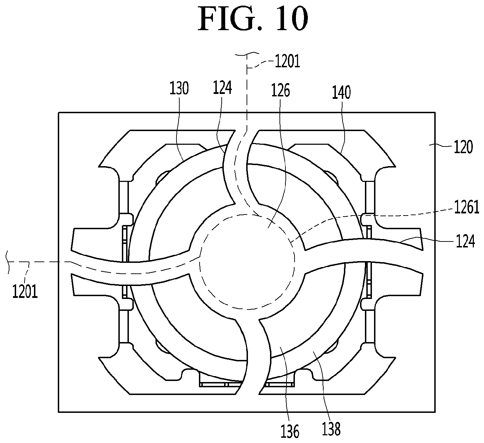

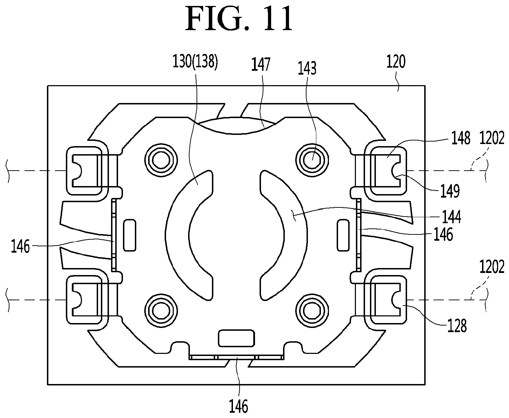

FIG. 4 is an exploded perspective view of the touch sensor assembly shown in FIG. 3, FIG. 5 is an enlarged view of a portion A of the touch substrate shown in FIG. 4, FIG. 6 is a front view and a rear view showing the other embodiments of the portion of the touch substrate shown in FIG. 5, FIG. 7 is an enlarged view and a side view of a portion B which is one of the piezo disks shown in FIG. 4, FIG. 8 is an enlarged view of a portion C which is one of holders shown in FIG. 4, FIG. 9 is a cross-sectional view of a piezo disk installation portion of the touch sensor assembly when viewed in an X-X direction of FIG. 2 in a state of assembling the touch sensor assembly of FIG. 4, FIG. 10 is a front view showing a state in which the touch substrate, the holder and the piezo disk of the touch sensor assembly of FIG. 4 are assembled, and FIG. 11 is a rear view of FIG. 10.

Hereinafter, the overall structure of the touch sensor assembly and the structures of the individual components configuring the touch sensor assembly will be described in detail with reference to FIGS. 4 to 11.

Referring to FIGS. 4 and 9, in the touch sensor assembly 100, a touch substrate 120 and a guide substrate 160 are stacked by a second adhesive member 150, thereby forming an overall appearance. The touch substrate and the guide substrate may be made of a printed circuit board (PCB) having a certain thickness. However, the guide substrate may not be made of a PCB and may be made of synthetic resin having the same shape, for example, a plastic injected part.

A holder 140 fixed to the touch substrate 120 and a piezo disk 130 inserted into the holder 140 are received in a reception hole 162 of the guide substrate 160. That is, the guide substrate 160 may function as a part of the body of the touch sensor assembly 100 while defining the overall appearance and function as a part of a housing for receiving various components installed in the touch sensor assembly. Accordingly, the material and molding method of the guide substrate 160 may be variously changed according to the function of the guide substrate 160.

A first adhesive member 110 such as a double-sided adhesive tape is adhered to an outer surface, that is, the opposite surface of the surface on which the guide substrate is stacked, of the touch substrate 120 to be water-tighten with respect to the touch substrate 120 and the structure stacked thereon and the outer surface of the touch substrate 120 may be attached to the rear surface of the front panel 20 of the refrigerator door.

A third adhesive member 170 made of P.E.T is attached to the outer surface, that is, the opposite surface of the surface on which the touch substrate is stacked, of the guide substrate 160 to be water-tighten with respect to the guide substrate 160 and the structure stacked thereon.

The touch substrate 120 corresponds to the touch region 22 including the plurality of touch points 21 provided on the front panel 20 configuring the door 10 of the refrigerator 1. In the embodiment of the present invention, the plurality of touch points 21 is arranged on the front panel 20 to be spaced apart from each other in a line and the touch region 22 is formed in an elongated rectangular shape (see FIGS. 1 to 3). Accordingly, the touch substrate 120 may be formed in an elongated rectangular shape.

Referring to FIG. 5, a hole 122 is provided in the touch substrate 120 at a position corresponding to the touch point 21 of the front panel 20. In the embodiment of the present invention, the hole is substantially rectangular but the shape of the hole is not limited thereto. The center of the hole 122 is aligned with the center of the touch point 21 of the front panel 20.

A plurality of leg parts 124 extending from an inner circumferential surface to the center of the hole is provided in the inner circumferential surface of the hole 122. A pressing part 126 aligned with the center of the hole is connected to the front ends of the leg parts 124. The shape of the pressing part 126 corresponds to that of a piezo disk and the size thereof may be slightly less than that of the piezo disk. In the present invention, the piezo disk and the circular pressing part 126 corresponding thereto are shown. The pressing part 126 and the inner circumferential surface of the hole 122 having the rectangular shape are connected to each other by the plurality of leg parts 124 extending from the center of each side of the rectangle to the pressing part.

The structure in which the hole 122 is provided in the touch substrate 120 and the pressing part 126 provided at the center of the hole is connected by the plurality of leg parts 124 makes the pressing part 126 flexible. That is, when the user presses the touch point 21 of the front panel, the pressing force is applied to the pressing part 126. Since the pressing part 126 is connected to the main body of the touch substrate 120 through the plurality of relatively thin leg parts 124, the pressing part 126 may be pressed by the pressing force of the user.

Accordingly, in the embodiment of the present invention, the structure in which the pressing part 126 is provided at the center of the hole 122 through the four leg parts 124 may be variously changed if the pressing part 126 is easily moved according to the touch pressure of the user and is designed to have sufficient durability against repeated pressing operations. As a modification of the embodiment (see FIGS. 5 and 6(a)) in which the four leg parts are provided at an interval of 90°, a structure in which three leg parts are provided at an interval of 90° as shown in (b) of FIG. 6, a cantilever structure in which only two leg parts are provided at an interval of 90° as shown in (c) of FIG. 6 or a straight type structure in which only two leg parts are provided at an interval of 180° as shown in (d) of FIG. 6 is applicable. In particular, since the cantilever structure is deformed so as to be more conformable to the touch pressure of the user, it is possible to further increase touch sensitivity.

Meanwhile, as shown in FIG. 5, fixing surfaces 128 for fixing the fixing leg parts 148 of the holder 140 are provided in the vicinity of the hole 122. Although the fixing surfaces 128 protruding toward the inside of the hole 122 in a substantially rectangular shape are provided in the embodiment, the positions of the fixing surfaces is not limited thereto.

Since the touch substrate 120 according to the first embodiment is formed in an elongated rectangular shape and the long side of the hole 122 having the rectangular shape is aligned in a direction corresponding to the longitudinal direction of the touch substrate, the touch substrate 120 may become slimmer. In addition, since the fixing surfaces 128 are provided at the short sides of the hole 122, an insertion hole 141 of the holder 140 may be configured to be opened toward the side surface of the touch substrate 120 and thus the piezo disk 130 may be more easily inserted.

The hole 122, the plurality of leg parts 124, the pressing part 126 and the fixing surface 128 may be simultaneously formed in the touch substrate 120, by punching the hole portion of the touch substrate except for the leg parts 124, the pressing part 126 and the fixing surface 128.

The touch substrate 120 includes electrical wirings, one of which is a first wiring 1201 passing through the pressing part 126 and the plurality of leg parts 124 and the other of which is a second wiring 1202 connected to the fixing surface, in order to determine whether pressure is applied to the piezo disk. That is, when pressure is applied to the piezo disk to generate a potential difference, electromotive force may be sensed through the wirings.

According to the present invention, a plurality of first wirings 1201 is provided. In addition, a plurality of second wirings 1202 may be provided.

Accordingly, the plurality of leg parts 124, through which the first wirings 1201 pass, and the plurality of fixing surfaces 128, to which the second wirings 1202 are connected, may be provided.

The plurality of first wirings 1201 may be provided, such that the plurality of first wirings 1201 passes through one leg part 124 or only one first wiring 1201 passes through one leg part 124. In addition, the plurality of first wirings 1201 may be connected to a plurality of points of the pressing part 126.

For example, the number of leg parts 124 may be four and the number of first wirings 1201 may be four such that the first wirings correspond to the leg parts.

In general, if force momentarily applied to the pressing part 126 is large or if the number of times of pressing the pressing part 126 is increased, the leg parts 124 supporting the pressing part 126 may be damaged. In addition, when the leg parts 124 are damaged, the first wirings 1201 passing through the leg parts 124 may be broken.

However, conventionally, it is impossible to prepare for damage of the leg parts 124 and breaking of the first wirings 1201.

However, in the present invention, since the plurality of leg parts 124 supporting the pressing part 126 is provided and the plurality of first wirings 1201 passing through the leg parts 124 is provided, even when any one of the plurality of leg parts 124 is damaged or any one of the plurality of first wirings 1201 is broken, the pressing part 126 may be supported by the other leg parts 124 which are not damaged and the electrical signal may be transmitted to the touch substrate 120 or a wafer 180 or a connector (not shown) by the other first wirings 1201 which are not broken.

In addition, the pressing part 126, the leg parts 124 and the first wirings 1201 passing through the leg parts 124 may have improved durability and an enhanced structure.

In the present invention, the leg parts 124 are formed in the curved shape and thus a load supported thereby may be greater than the load supported by the leg parts 124 having a straight shape.

Specifically, when the leg parts 124 are formed in the curved shape, elastic deformation is easy, fatigue strength is increased, flexibility is secured, such that the leg parts 124 are not easily broken even when the leg parts 124 are repeatedly used.

That is, in the present invention, since the leg parts 124 are formed in a curved line (arch shape), even if force momentarily applied to the pressing part 126 is large or if the number of times of pressing the pressing part 126 is increased, the possibility of damaging the leg parts may be reduced as compared to the straight leg parts.

Since the first wirings 1201 passing through the leg parts 124 are formed in a curved shape, the possibility of breaking the first wirings may be reduced similarly to the leg parts 124.

Referring to FIGS. 4 and 9, the guide substrate 160 is an injected part having the touch substrate 120 stacked thereon with the second adhesive member 150 interposed therebetween. The second adhesive member 150 may be a double-sided adhesive tape adhered to the two substrates 120 and 160.

The guide substrate 160 is formed in a rectangular flat plate to correspond to the touch substrate 120 and reception holes 162 are provided at positions corresponding to the holes 122 of the touch substrate 120.

The reception hole 162 has an area capable of receiving at least the holder 140 and the piezo disk 130 received in the holder 140 and the thickness of the guide substrate 160 is equal to or slightly greater than the height of the holder 140. Accordingly, in a state in which the holder 140 is received in the reception hole 162, the holder does not protrude from the surface of the guide substrate 160.

Since the holder 140 is installed in the hole portion of the touch substrate 120, the second adhesive member 150 includes a through-hole 152 having the position and shape corresponding to those of the reception hole 162 of the guide substrate 160.

Referring to FIGS. 4, 8 and 9, the holder 140 is fixed to the portion of the hole 122 of the touch substrate 120. When the holder 140 is fixed to the touch substrate 120, the piezo disk may be inserted into and fixed in a space provided by the holder and the touch substrate.

The holder 140 includes a rear support part 142 substantially covering the portion of the hole 122 of the touch substrate and having a rectangular shape. (Strictly speaking, although the shape of the rear support part 142 is substantially a square, for convenience, the shape of the rear support part 142 is described as being a rectangular shape in correspondence with the rectangular hole 122 of the touch substrate 120.) When the holder is fixed to the touch substrate, the rear support part 142 is spaced apart from the surface of the touch substrate by a predetermined gap. The gap between the rear support part 142 and the surface of the touch substrate may be defined by side support parts 146 bent on the outer edge of the rear support part at a substantially right angle. Fixing leg parts 148 fixed to the fixing surfaces 128 of the touch substrate 120 through soldering are provided on the ends of the side support parts 146. The fixing leg parts 148 are electrically connected to the fixing surfaces 128 through soldering.

In some the embodiments, a total of four fixing surfaces 128 of the touch substrate is provided at the short side portions of the rectangular hole 122 and four fixing leg parts 148 are provided at positions corresponding to the fixing surfaces. Each fixing leg part 148 is formed in a planar shape to be in contact with the fixing surface 128, and a via hole 149 may be formed in an end of the fixing leg part in order to increase soldering adhesion with the fixing surface 128. The fixing leg parts 148 are arranged in the longitudinal direction of the touch substrate 120, such that the insertion hole 141 of the holder is opened toward the lateral side (that is, the direction perpendicular to the longitudinal direction) of the touch substrate 120, thereby more easily inserting the piezo disk.

The side support parts 146 are bent at a right angle on two short sides and one long side among the four sides of the rectangular rear support part 142. The side support parts 146 prevent the piezo disk 130 from being separated from the holder 140 in a process of supporting and assembling the side surface of the piezo disk 130 to be inserted into the holder 140. The fixing leg parts 148 are provided at the portions of the side support parts 146 where the two short sides of the rear support part 142 are bent. The long side, on which the side support part 146 is not provided, of the rear support part 142 becomes the insertion hole 141, through the piezo disk 130 is inserted. An arc-shaped guide groove 147 guiding the end of the disk toward the insertion hole 141 upon inserting the piezo disk 130 having the circular plate is provided in the long side portion, which becomes the insertion hole 141, of the side support part 146.

The rear support part 142 becomes a portion supporting the rear surface 134 of the piezo disk 130. Pressing projections 143 pressing and supporting the edges of the rear surface of the piezo disk 130 are provided in the vicinities of the outer edges of the rear support part 142. The pressing projections 143 are provided at positions deviating from a first pole 136 provided on the front surface of the piezo disk 130.

The portion of the first pole 136 provided at the central part of the front surface 132 of the piezo disk 130 slightly protrudes from the front surface of the piezo disk. Such a first pole portion is in contact with the pressing part 126 of the touch substrate and is pressed and supported by the touch substrate. Accordingly, when the pressing projections 143 are provided at the positions deviating from the first pole 136 provided on the front surface of the piezo disk 130, the pressing part 126, which is flexibly moved by the leg parts 124 of the touch substrate 120 to some extent, presses the first pole 136 protruding from the front surface 132 of the piezo disk 130 and the pressing projections 143 of the holder 140 press the edges of the rear surface 134 of the piezo disk 130 deviating from the first pole 136, thereby tightly supporting the piezo disk 130 while minimizing the load applied to a portion where the potential difference of the piezo disk 130 is generated.

In addition, slits 144 having an arc shape are provided around the central point of the rear support part 142 of the holder. Such slits 144 are provided inside the pressing projections 143. The slits 144 may facilitate deformation of the vicinities of the slits. Accordingly, the central portion of the rear support part may be deformed according to deformation of the central portion of the rear surface of the piezo disk 130 which may be finely bent toward the rea surface by the pressing part 126 and the pressing projections 143. The same is true even when the user presses the touch point 21 of the front panel.

The holder 140 may be made of a conductive material such as metal, and a planar metal plate is subjected to press processing or piercing to easily form the pressing projections, the slits, the side support part, etc. That is, the holder 140 is electrically connected to the second wirings 1202 through the fixing surface 128.

Referring to FIG. 7, the piezo disk 130 includes a second pole 138 of a metal plate having a front surface 132 and a rear surface 134 and a first pole 136 stacked on the central portion of the front surface 132. The first pole 136 slightly protrudes from the surface of the second pole 138 at the central portion thereof. The first pole 136 may be made of ceramic and the second pole 138 may be made of a conductive material such as metal. In addition, a conductive layer 1361 such as silver (Ag) may be coated on the surface of the first pole 136.

The piezo disk 130 may be formed in the form of a circular plate and the diameter thereof may be equal to or slightly less than a gap between the two side support parts where the two short sides of the rear support part of the holder are bent.

The piezo disk 130 may be inserted between the touch substrate 120 and the holder 140 fixed to the touch substrate 120 and the guide groove 147 guides insertion of the piezo disk 130 upon inserting the piezo disk. When the piezo disk 130 is inserted, the front surface 132, on which the first pole 136 is provided, faces the touch substrate 120 and the rear surface 134 faces the holder.

When pressure is applied between the first pole and the second pole of the piezo disk 130, a potential difference is generated between the first pole and the second pole. According to the principle of the piezo disk 130, the wiring surface of the pressing part 126 of the touch substrate 120 which is in contact with the first pole 136 of the front surface 132 is exposed to be electrically connected to the first pole, and the wirings 1201 are not exposed so as not to be energized even when the leg part 124 of the touch substrate 120 is in contact with the second pole 138.

In addition, the wiring surface of the pressing part 126 may include a connection material 1261 made of copper or gold and the plurality of first wirings 1201 may be electrically connected to the connection material 1261.

The holder 140 is made of a metal material having electrical conductivity and is electrically connected to the second pole 138 of the rear surface 134. Since the connection material exposed to the pressing part 126 may be corroded over time, a solder may be thinly coated on the exposed wiring surface. Meanwhile, such a connection material is exposed to the fixing surface but the fixing surface is soldered to the fixing leg part 148 of the holder. Therefore, it is possible to omit apply the solder.

The first wirings 1201 of the pressing part 126 are connected to the touch substrate 120 through the leg parts 124 to be connected to the wafer 180 and the fixing surface 128 of the touch substrate soldered to the fixing leg parts 148 of the holder 140 are connected to the touch substrate 120 through the second wirings 1202 to be connected to the wafer 180.

Accordingly, when the user presses the touch point 21, the pressing part 126 is pressed with predetermined force F to press the piezo disk 130. At this time, since the pressing part 126 presses the central portion of the front surface 132 of the piezo disk and the pressing projections 143 of the holder 140 supports the edges of the rear surface 134 of the disk, the piezo disk 130 is deformed by the moment M and a potential difference is generated between the first pole 136 and the second pole 138. Minute current according to electromotive force generated by this process is transmitted through the wirings of the touch substrate and the wafer 180 to recognize that the touch point 21 is touched.

In some embodiments, a plurality of piezo disks is installed on the touch substrate. According to the embodiment of the present invention, the wafer 180 for electrical connection with the piezo disk of the touch sensor assembly is provided outside the touch sensor assembly.

Referring to FIG. 4, the wafer 180 is installed on the touch substrate 120. According to the embodiments, the wafer 180 may be installed in a space between the holes of the touch substrate 120 on which the piezo disks 130 are installed and are installed on the same surfaces as the surface, on which the holders 140 are fixed, of the touch substrate.

In order to receive the wafer 180, an opening hole 164 is provided in the guide substrate 160. The opening hole 164 is opened at the side surface of the guide substrate 160 and an opening hole 154 is provided at a corresponding position of the second adhesive member 150 in correspondence with the shape of the opening hole 164. In addition, an opening hole 174 is also provided in the third adhesive member 170 in correspondence with the opening hole 164. A connector (not shown) fitted in the wafer 180 may approach the wafer 180 in the direction of the opening hole and may be fastened to the wafer 180.

Hereinafter, the order of assembling the touch sensor assembly will be described with reference to FIGS. 4 to 9.

First, the holder 140 is soldered and fixed to the rear surface (the opposite surface of the surface facing the front panel) of the touch substrate 120. Then, the wafer 180 is installed by an automated process.

Next, the piezo disk 130 is inserted between the holder 140 and the touch substrate 120. Since insertion of the piezo disk is guided by the guide groove 147 when the piezo disk 130 is inserted, it is possible to more easily insert the piezo disk. In addition, since the piezo disk 130 is circular but the side surface support 146 of the holder 140 substantially corresponds to the side of the rectangle, when only an end of the piezo disk 130 is inserted into the insertion part and the piezo disk is pressed from behind, the circular edge of the piezo disk 130 guides the piezo disk 130 such that the piezo disk is naturally aligned and inserted into the holder.

In particular, according to the embodiments, since the touch substrate 120 has an elongated rectangular shape, the long sides of the rectangular holes 122 are aligned in a direction corresponding to the longitudinal direction of the touch substrate, and the insertion parts of the holders 140 are provided in correspondence with the long sides of the holes, it is possible to insert the piezo disks 130 into the holders 140 at the side surface of the touch substrate 120. Therefore, insertion is more easily performed.

The front surface and the rear surface of the touch portions of the touch sensor assembly in a semi-assembled state in which the holder 140 is fixed to the touch substrate 120 and the piezo disk 130 is inserted are shown in FIGS. 10 and 11, respectively.

Next, the touch substrate 120 and the guide substrate 160 are stacked with the second adhesive member 150 interposed therebetween, the first adhesive member 110 is stacked on the front surface (the surface facing the front panel) of the touch substrate 120, and the third adhesive member 170 is stacked on the rear surface of the guide substrate 160. This may be performed through an automated process.

The first adhesive member 110 is stacked in a state of attaching a release paper is attached to the surface thereof and the release paper is removed when the touch sensor assembly 100 is attached to the front panel 20 of the refrigerator door 10, thereby preventing the adhesive strength of the surface of the first adhesive member 110 from being deteriorated.

In the above-described embodiments, the structure of the touch sensor assembly of the refrigerator and the method of manufacturing the same have been described. However, the above-described touch sensor assembly is applicable to various fields such as vehicle door panels, including the other types of home appliances, in addition to the refrigerator.

While the present invention has been particularly shown and described with reference to exemplary embodiments thereof, it is to be understood that the invention is not limited to the disclosed exemplary embodiments, but is limited solely by the appended claims. In addition, although the operation and effect according to the configuration of the present invention have not been explicitly described while describing the embodiments of the present invention, it is needless to say that a predictable effect is also recognized by the configuration.

## Claims

1. A touch sensor assembly (100) comprising:
a touch substrate (120) configured to be attached to a panel (20) having a touch point (21); and
a piezo disk (130) having a first pole (136) and a second pole (138) stacked thereon, the first pole (136) being disposed on a surface of the second pole (138) facing the touch substrate (120);
wherein the touch substrate (120) includes a pressing part (126), which is in contact with the first pole (136) and electrically connected thereto, and which is electrically connected at a plurality of points to a plurality of first wirings (1201) provided on the touch substrate (120) and a fixing surface (128) electrically connected to the second pole (138) and electrically connected to second wirings (1202) provided on the touch substrate (120).

2. The touch sensor assembly (100) according to claim 1, wherein the pressing part (126) is provided at a position of the touch substrate (120) corresponding to the touch point (21).

3. The touch sensor assembly (100) according to claim 1 or 2, wherein the pressing part (136) is provided within a hole in the touch substrate (120) and a plurality of leg parts (124) connects the pressing part (126) to a circumferential surface of the hole (122), so that the pressing part (126) is flexibly provided on the touch substrate (120).

4. The touch sensor assembly (100) according to claim 3, wherein the plurality of first wirings (1201) is electrically connected to the pressing part (126) through at least two of the plurality of leg parts (124).

5. The touch sensor assembly (100) according to claims 3 or 4 , wherein the leg parts (124) are provided radially around the pressing part and/or are provided asymmetrically with respect to the pressing part (126).

6. The touch sensor assembly (100) according to any one of claims 3 to 5, wherein the leg parts (124) and the first wirings (1201) passing on the leg parts (124) are formed in a curved shape.

7. The touch sensor assembly (100) according to anyone of the preceding claims, further comprising a holder (140) for fixing the piezo disk (130) to the touch substrate (120) by supporting a rear surface of the piezo disk (130) facing away from the touch substrate (120), the holder (140) being fixed to the fixing surface (128).

8. The touch sensor assembly (100) according to claim 7,
wherein the holder includes a conductive material, and
wherein the second pole (138) of the piezo disk (130) is electrically connected to the fixing surface (128) by the holder (140).

9. The touch sensor assembly (100) according to claim 7 or 8, wherein the holder (140) includes:
a rear support part (142) supporting the rear surface of the piezo disk (130);
a side support part (146) extending from the rear support part (142) toward the touch substrate (120) to support a side surface of the piezo disk (130); and
a fixing leg part (148) extending from the side support part (146) and fixed to the fixing surface (128) of the touch substrate (120).

10. The touch sensor assembly (100) according to any one of claims 7 to 9, wherein an insertion hole (141) for inserting the piezo disk (130) between the touch substrate (120) and the holder (140) is formed in one side of the holder (140).

11. The touch sensor assembly (100) according to claim 10, wherein a guide groove (147) is recessed inward from an edge of the holder (140) including the insertion hole (141) in order to guide insertion of the piezo disk (130).

12. The touch sensor assembly (100) according to any one of claims 9 to 11,
wherein pressing projections (143) for pressing the piezo disk (130) towards the touch substrate (120) are provided on the rear support part.

13. The touch sensor assembly (100) according to claim 12, wherein the pressing part (126) is configured to press a central portion of the piezo disk (130) and the pressing projections (143) are configured to press portions of the piezo disk (130) outside the central potion.

14. The touch sensor assembly (100) according to any one of claims 9 to 13, wherein slits (144) are formed around the center of the rear support part (142).

15. The touch sensor assembly (100) according to claim 1, wherein a first adhesive member (110) is provided on the touch substrate (120) for adhering the touch substrate (120) to the panel (20).

## Patentansprüche

1. Berührungssensoranordnung (100), die Folgendes umfasst:
ein Berührungssubstrat (120), das konfiguriert ist, an einer Tafel (20) angebracht zu sein, die einen Berührungspunkt (21) aufweist; und
eine Piezo-Scheibe (130), die einen ersten Pol (136) und einen zweiten Pol (138) aufweist, die darauf gestapelt sind, wobei der erste Pol (136) auf einer Fläche des zweiten Pols (138) angeordnet ist, die dem Berührungssubstrat (120) zugewandt ist;
wobei das Berührungssubstrat (120) einen Drückabschnitt (126), der sich mit dem ersten Pol (136) in Kontakt befindet und damit elektrisch verbunden ist und der an mehreren Punkten mit mehreren ersten Verdrahtungen (1201), die auf dem Berührungssubstrat (120) vorgesehen sind, elektrisch verbunden ist, und eine Befestigungsfläche (128), die mit dem zweiten Pol (138) elektrisch verbunden ist und mit zweiten Verdrahtungen (1202), die auf dem Berührungssubstrat (120) vorgesehen sind, elektrisch verbunden ist.

2. Berührungssensoranordnung (100) nach Anspruch 1, wobei der Drückabschnitt (126) an einer Position des Berührungssubstrats (120) vorgesehen ist, die dem Berührungspunkt (21) entspricht.

3. Berührungssensoranordnung (100) nach Anspruch 1 oder 2, wobei der Drückabschnitt (136) in einem Loch im Berührungssubstrat (120) vorgesehen ist und mehrere Beinabschnitte (124) den Drückabschnitt (126) mit einer Umfangsfläche des Lochs (122) verbinden, derart, dass der Drückabschnitt (126) auf dem Berührungssubstrat (120) flexibel vorgesehen ist.

4. Berührungssensoranordnung (100) nach Anspruch 3, wobei die mehreren ersten Verdrahtungen (1201) durch mindestens zwei der mehreren Beinabschnitte (124) mit dem Drückabschnitt (126) elektrisch verbunden sind.

5. Berührungssensoranordnung (100) nach Anspruch 3 oder 4, wobei die Beinabschnitte (124) um den Drückabschnitt radial vorgesehen sind und/oder in Bezug auf den Drückabschnitt (126) unsymmetrisch vorgesehen sind.

6. Berührungssensoranordnung (100) nach einem der Ansprüche 3 bis 5, wobei die Beinabschnitte (124) und die ersten Verdrahtungen (1201), die auf den Beinabschnitten (124) verlaufen, in einer gekrümmten Form ausgebildet sind.

7. Berührungssensoranordnung (100) nach einem der vorhergehenden Ansprüche, die ferner einen Halter (140) zum Befestigen der Piezo-Scheibe (130) am Berührungssubstrat (120) durch Tragen einer rückwärtigen Fläche der Piezo-Scheibe (130), die vom Berührungssubstrat (120) abgewandt ist, umfasst, wobei der Halter (140) an der Befestigungsfläche (128) befestigt ist.

8. Berührungssensoranordnung (100) nach Anspruch 7,
wobei der Halter ein leitfähiges Material enthält, und
wobei der zweite Pol (138) der Piezo-Scheibe (130) durch den Halter (140) mit der Befestigungsfläche (128) elektrisch verbunden ist.

9. Berührungssensoranordnung (100) nach Anspruch 7 oder 8, wobei der Halter (140) Folgendes enthält:
einen rückwärtigen Trägerabschnitt (142), der die rückwärtige Fläche der Piezo-Scheibe (130) trägt;
einen Seitenträgerabschnitt (146), der sich vom rückwärtigen Trägerabschnitt (142) in Richtung des Berührungssubstrats (120) erstreckt, um eine Seitenfläche der Piezo-Scheibe (130) zu tragen; und
einen Befestigungsbeinabschnitt (148), der sich vom Seitenträgerabschnitt (146) erstreckt und an der Befestigungsfläche (128) des Berührungssubstrats (120) befestigt ist.

10. Berührungssensoranordnung (100) nach einem der Ansprüche 7 bis 9, wobei ein Einsatzloch (141) zum Einsetzen der Piezo-Scheibe (130) zwischen dem Berührungssubstrat (120) und dem Halter (140) in einer Seite des Halters (140) gebildet ist.

11. Berührungssensoranordnung (100) nach Anspruch 10, wobei eine Führungsrille (147) von einer Kante des Halters (140), der das Einsatzloch (141) enthält, nach innen vertieft ist, um das Einsetzen der Piezo-Scheibe (130) zu führen.

12. Berührungssensoranordnung (100) nach einem der Ansprüche 9 bis 11,
wobei Drückvorsprünge (143) zum Drücken der Piezo-Scheibe (130) in Richtung des Berührungssubstrats (120) auf dem rückwärtigen Trägerabschnitt vorgesehen sind.

13. Berührungssensoranordnung (100) nach Anspruch 12, wobei der Drückabschnitt (126) konfiguriert ist, auf einen Mittelabschnitt der Piezo-Scheibe (130) zu drücken, und die Drückvorsprünge (143) konfiguriert sind, auf Abschnitte der Piezo-Scheibe (130) außerhalb des Mittelabschnitts zu drücken.

14. Berührungssensoranordnung (100) nach einem der Ansprüche 9 bis 13, wobei um die Mitte des rückwärtigen Trägerabschnitts (142) Schlitze (144) gebildet sind.

15. Berührungssensoranordnung (100) nach Anspruch 1, wobei ein erstes Haftelement (110) zum Anhaften des Berührungssubstrats (120) an der Tafel (20) auf dem Berührungssubstrat (120) vorgesehen ist.

## Revendications

1. Ensemble de capteur tactile (100) comportant :
un substrat tactile (120) configuré pour être fixé à un panneau (20) ayant un point tactile (21) ; et
un disque piézo-électrique (130) ayant un premier pôle (136) et un second pôle (138) empilés sur celui-ci, le premier pôle (136) étant disposé sur une surface du second pôle (138) dirigée vers le substrat tactile (120) ;
dans lequel le substrat tactile (120) inclut une partie de pression (126), qui est en contact avec le premier pôle (136) et électriquement connectée à celui-ci, et qui est électriquement connectée en une pluralité de points à une pluralité de premiers câblages (1201) agencés sur le substrat tactile (120) et une surface de fixation (128) électriquement connectée au second pôle (138) et électriquement connectée à des seconds câblages (1202) agencés sur le substrat tactile (120).

2. Ensemble de capteur tactile (100) selon la revendication 1, dans lequel la partie de pression (126) est disposée sur une position du substrat tactile (120) correspondant au point tactile (21).

3. Ensemble de capteur tactile (100) selon la revendication 1 ou 2, dans lequel la partie de pression (136) est agencée à l'intérieur d'un trou dans le substrat tactile (120) et une pluralité de parties de canal (124) relie la partie de pression (126) à une surface circonférentielle du trou (122), de sorte que la partie de pression (126) est agencée sur le substrat tactile (120) de manière flexible.

4. Ensemble de capteur tactile (100) selon la revendication 3, dans lequel la pluralité de premiers câblages (1201) est électriquement connectée à la partie de pression (126) par l'intermédiaire d'au moins deux parties de la pluralité de parties de canal (124).

5. Ensemble de capteur tactile (100) selon les revendications 3 ou 4, dans lequel les parties de canal (124) sont agencées radialement autour de la partie de pression et/ou sont agencées de manière asymétrique par rapport à la partie de pression (126).

6. Ensemble de capteur tactile (100) selon l'une quelconque des revendications 3 à 5, dans lequel les parties de canal (124) et les premiers câblages (1201) passant sur les parties de canal (124) sont formés avec une forme incurvée.

7. Ensemble de capteur tactile (100) selon l'une quelconque des revendications précédentes, comportant en outre un support (140) pour fixer le disque piézo-électrique (130) sur le substrat tactile (120) en supportant une surface arrière du disque piézo-électrique (130) en s'écartant du substrat tactile (120), le support (140) étant fixé à la surface de fixation (128).

8. Ensemble de capteur tactile (100) selon la revendication 7,
dans lequel le support inclut un matériau conducteur, et
dans lequel le second pôle (138) du disque piézo-électrique (130) est électriquement connecté à la surface de fixation (128) par le support (140).

9. Ensemble de capteur tactile (100) selon la revendication 7 ou 8, dans lequel le support (140) inclut :
une partie de support arrière (142) supportant la surface arrière du disque piézo-électrique (130) ;
une partie de support latérale (146) s'étendant depuis la partie de support arrière (142) vers le substrat tactile (120) pour supporter une surface latérale du disque piézo-électrique (130) ; et
une partie de canal de fixation (148) s'étendant depuis la partie de support latérale (146) et fixée à la surface de fixation (128) du substrat tactile (120).

10. Ensemble de capteur tactile (100) selon l'une quelconque des revendications 7 à 9, dans lequel un trou d'insertion (141) pour insérer le disque piézo-électrique (130) entre le substrat tactile (120) et le support (140), est formé dans un côté du support (140).

11. Ensemble de capteur tactile (100) selon la revendication 10, dans lequel une rainure de guidage (147) est évidée vers l'intérieur depuis un bord du support (140) incluant le trou d'insertion (141) afin de guider une insertion du disque piézo-électrique (130).

12. Ensemble de capteur tactile (100) selon l'une quelconque des revendications 9 à 11, dans lequel des saillies de pression (143) pour presser le disque piézo-électrique (130) vers le substrat tactile (120) sont prévues sur la partie de support arrière.

13. Ensemble de capteur tactile (100) selon la revendication 12, dans lequel la partie de pression (126) est configurée pour presser une portion centrale du disque piézo-électrique (130) et les saillies de pression (143) sont configurées pour presser des portions du disque piézo-électrique (130) à l'extérieur de la portion centrale.

14. Ensemble de capteur tactile (100) selon l'une quelconque des revendications 9 à 13, dans lequel des fentes (144) sont formées autour du centre de la partie de support arrière (142).

15. Ensemble de capteur tactile (100) selon la revendication 1, dans lequel un premier élément adhésif (110) est prévu sur le substrat tactile (120) pour faire adhérer le substrat tactile (120) au panneau (20).
